# EUROPEAN PATENT APPLICATION

(11) **EP 2 978 014 A1**
(43) Date of publication of application: **27.01.2016**
(21) Application number: 14769117.4
(22) Date of filing: 30.01.2014
(51) Int. Cl.: H01L 21/56, H01L 23/29, H01L 23/31, H01L 33/48

(54) **ADHERING APPARATUS AND METHOD FOR MANUFACTURING ELECTRONIC APPARATUS**

(30) Priority: 18.03.2013 JP 2013055249
(71) Applicant: Nitto Denko Corporation, Ibaraki-shi, Osaka 567-8680 (JP)
(72) Inventor: MITANI, Munehisa, Ibaraki-shi Osaka 567-8680 (JP); OOYABU, Yasunari, Ibaraki-shi Osaka 567-8680 (JP); TSUKAHARA, Daisuke, Ibaraki-shi Osaka 567-8680 (JP)
(74) Representative: Hoffmann Eitle
(86) International application number: PCT/JP2014/052123
(87) International publication number: WO 2014/148119

(57) **Abstract**

The adhering device is an adhering device for adhering a resin sheet to an electronic component. The adhering device includes a first mold member having a first cavity in which an adhering preform can be accommodated, the adhering perform including the electronic component and the resin sheet disposed to face the electronic component in spaced-apart relation; an elastic member disposed to face the resin sheet so that a first enclosed space can be formed with the first cavity; and a differential pressure generation means connected to the first mold member for allowing the air pressure of the first enclosed space to be lower than the air pressure of a space opposite to the first enclosed space relative to the elastic member. The adhering device is configured such that by operating the differential pressure generation means, the elastic member moves towards the first cavity side, and therefore, the adhering perform is pressed in the direction facing the electronic component and the resin sheet, thereby adhering the resin sheet to the electronic component.

## Description

### TECHNICAL FIELD

The present invention relates to an adhering device and a method for producing an electronic device. In particular, the present invention relates to an adhering device, and to a method for producing an electronic device in which the adhering device is used to adhere a resin sheet to electronic components.

### BACKGROUND ART

Conventionally, it has been known that electronic devices such as optical semiconductor devices are produced by adhering a resin sheet, for example, an encapsulating sheet to electronic components such as optical semiconductor elements and condensers.

Patent Document 1 below has proposed, for example, a method in which an encapsulating sheet is disposed to face a board on which a light-emitting diode is mounted, and then they are pressed with a flat-plate press.

### Citation List

### Patent Document

Patent Document 1: Japanese Unexamined Patent Publication No. 2013-21284

### SUMMARY OF THE INVENTION

### PROBLEM TO BE SOLVED BY THE INVENTION

However, in the method proposed in Patent Document 1, an encapsulating sheet and a board on which a light-emitting diode is mounted are placed in a flat-plate pressing device, and then they are pressed using the flat-plate pressing device. The flat-plate pressing device includes two pressing plates (mold), and a pressure application source for applying a pressure, and it is usually large.

Meanwhile, there are demands for the pressing device for producing electronic devices to be small depending on its application and purpose. However, the flat-plate pressing device described in Patent Document 1 is disadvantageous in that the above-described demands are not easily satisfied.

Furthermore, there is a demand for an adhering device such as a pressing device depending on its application and purpose that the adhering device is transported to a desired location. However, the flat-plate pressing device described in Patent Document 1 is large, and therefore it is disadvantageous in that the above-described demand is not easily satisfied.

An object of the present invention is to provide an adhering device having a small size and excellent transportability, and a method for producing an electronic device that allows for easy production of electronic devices using the adhering device.

### MEANS FOR SOLVING THE PROBLEM

An adhering device of the present invention is an adhering device for adhering a resin sheet to an electronic component, and includes
a first mold member having a first cavity in which an adhering preform can be accommodated, the adhering preform including the electronic component and the resin sheet disposed to face the electronic component in spaced-apart relation,
an elastic member disposed to face the resin sheet so that a first enclosed space can be formed with the first cavity, and
a differential pressure generation means connected to the first mold member for allowing the air pressure of the first enclosed space to be lower than the air pressure of a space opposite to the first enclosed space relative to the elastic member,
wherein the adhering device is configured so that by operating the differential pressure generation means, the elastic member moves towards the first cavity side, and therefore, the adhering preform is pressed in the direction facing the electronic component and the resin sheet, thereby adhering the resin sheet to the electronic component.

The adhering device includes a first mold member, an elastic member, and a differential pressure generation means, and therefore the device configuration can be made simple, thereby achieving a small size. Furthermore, a small size adhering device is excellent in transportability.

With the adhering device, by operating the differential pressure generation means, the elastic member moves towards the first cavity side. Therefore, the adhering preform is pressed in the direction facing the electronic component and the resin sheet so that the resin sheet can be reliably adhered to the electronic component.

In the adhering device of the present invention, it is preferable that the first mold member and the elastic member are provided separately from the differential pressure generation means.

In the adhering device, the first mold member and the elastic member are separately provided from the differential pressure generation means, and therefore the first mold member and the elastic member, and the differential pressure generation means are disposed independently from each other to achieve a small size.

In the adhering device of the present invention, it is preferable that the first mold member is configured so that the electronic component and/or the resin sheet are visible.

In the adhering device, the first mold member is configured so that the electronic component and/or the resin sheet are visible, and therefore the adhering status of the electronic component and/or the resin sheet can be visually checked through the first mold member.

It is preferable that the adhering device of the present invention includes a second mold member disposed to face the first mold member with the elastic member sandwiched therebetween,
wherein the second mold member has a second cavity facing the first cavity with the elastic member sandwiched therebetween and capable of forming a second enclosed space, the second enclosed space enclosing, with the elastic member, the space opposite to the first enclosed space relative to the elastic member.

In the adhering device, the second mold member has a second cavity that is capable of forming the second enclosed space, and therefore the second cavity allows for the air pressure of the second enclosed space to be reliably higher than the air pressure of the first enclosed space to reliably move the elastic member to the first cavity side.

In the adhering device of the present invention, it is preferable that the adhering perform includes
a board on which the electronic component is mounted,
a first support plate disposed on the opposite side to the electronic component relative to the board, for supporting the board, and
a second support plate disposed on the opposite side to the board relative to the resin sheet, for supporting the resin sheet.

In the adhering device, each of the first support plate and the second support plate allows for reliable retention of the adhesion attitude of each of the board on which the electronic component is mounted and the resin sheet. Therefore, the resin sheet can be precisely adhered to the electronic component.

A method for producing an electronic device of the present invention is a method for producing an electronic device by adhering a resin sheet to an electronic component using the above-described adhering device, the method including:
a placement step in which an adhering perform is placed in the first enclosed space of the adhering device, and
an adhering step in which by operating a differential pressure generation means, the air pressure of the first enclosed space is allowed to be lower than the air pressure of a space opposite to the first enclosed space relative to the elastic member to move the elastic member towards the first cavity side, and therefore, the adhering preform is pressed in the direction facing the electronic component and the resin sheet, thereby adhering the resin sheet to the electronic component.

In the method, in the adhering step, by operating the differential pressure generation means, the air pressure of the first enclosed space is allowed to be lower than the air pressure of a space opposite to the first enclosed space relative to the elastic member to move the elastic member to the first cavity side, and therefore, the adhering preform is pressed in the direction facing the electronic component and the resin sheet, thereby reliably adhering the resin sheet to the electronic component.

Thus, with a simple method in which the air pressure of the first enclosed space is allowed to be lower than the air pressure of the space opposite to the first enclosed space, the resin sheet can be reliably adhered to the electronic component.

In the method for producing an electronic device of the present invention, it is preferable that the adhering step includes a decompression step in which the pressure of the first enclosed space and the space opposite to the first enclosed space are both decreased, and
a differential pressure generation step in which after the decompression step, by allowing the air pressure of a space opposite to the first enclosed space to be atmospheric pressure, the air pressure of the first enclosed space is allowed to be lower than the air pressure of the space opposite to the first enclosed space.

With the method, by reducing the pressures of the first enclosed space and the space opposite to the first enclosed space, and thereafter introducing atmospheric air into the space opposite to the first enclosed space, the space opposite to the first enclosed space is allowed to have the atmospheric pressure. The air pressure of the first enclosed space can rapidly be lower than the air pressure of the space opposite to the first enclosed space. Thus, the elastic member can be rapidly moved toward the first cavity side to efficiently adhere the resin sheet to the electronic component.

### EFFECT OF THE INVENTION

The adhering device of the present invention allows for a simple device configuration, and therefore can achieve a small size. Furthermore, a small size adhering device is excellent in transportability. In addition, the resin sheet allows for reliable adhesion of the electronic component.

Furthermore, with the method for producing an electronic device of the present invention, the resin sheet can be reliably adhered to the electronic component by a simple method.

### BRIEF DESCRIPTION OF THE DRAWINGS

FIG. 1 is a front sectional view of an encapsulating device as an embodiment of an adhering device of the present invention, and shows a decompression step in a method for producing an optical semiconductor device as an embodiment of a method for producing an electronic device of the present invention.
FIG. 2 shows an exploded cross-sectional view of the encapsulating device shown in FIG. 1.
FIG. 3 is a cross-sectional view of the encapsulating device shown in FIG. 1, and shows a differential pressure generation step in a method for producing an optical semiconductor device as an embodiment of the method for producing an electronic device of the present invention.
FIG. 4 is a cross-sectional view of the encapsulating device shown in FIG. 1, and shows a retrieve step in a method for producing an optical semiconductor device as an embodiment of the method for producing an electronic device of the present invention.
FIG. 5 is a front sectional view of a variation of the encapsulating device as an embodiment of the adhering device of the present invention, and shows a differential pressure generation step.
FIG. 6 is a front sectional view of a variation of the encapsulating device as an embodiment of the adhering device of the present invention, and shows a differential pressure generation step.
FIG. 7 is a front sectional view of a variation of the encapsulating device as an embodiment of the adhering device of the present invention, and shows a differential pressure generation step.
FIG. 8 is a front sectional view of a variation of the encapsulating device as an embodiment of the adhering device of the present invention, and shows a placement step.
FIG. 9 is a front sectional view of the encapsulating device shown in FIG. 8, and shows a differential pressure generation step.
FIG. 10 is a front sectional view of a variation of the encapsulating device as an embodiment of the adhering device of the present invention, and shows a placement step.
FIG. 11 is a front sectional view of the encapsulating device shown in FIG. 10, and shows a differential pressure generation step.

### DESCRIPTION OF EMBODIMENTS

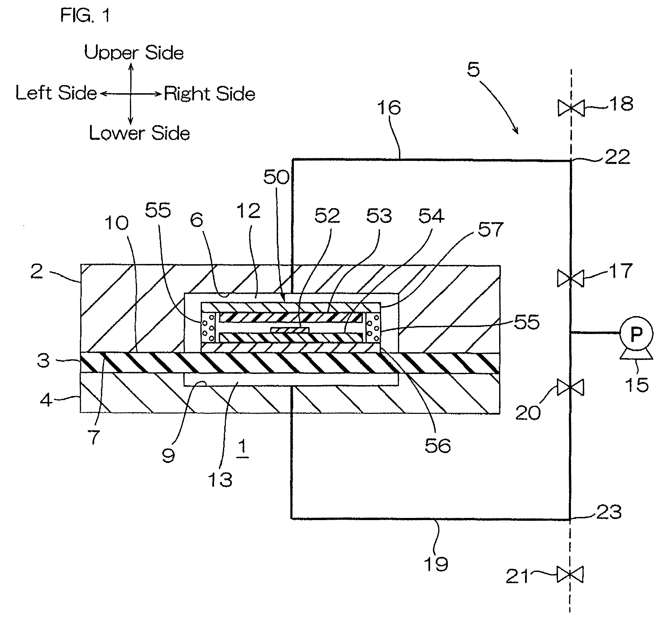

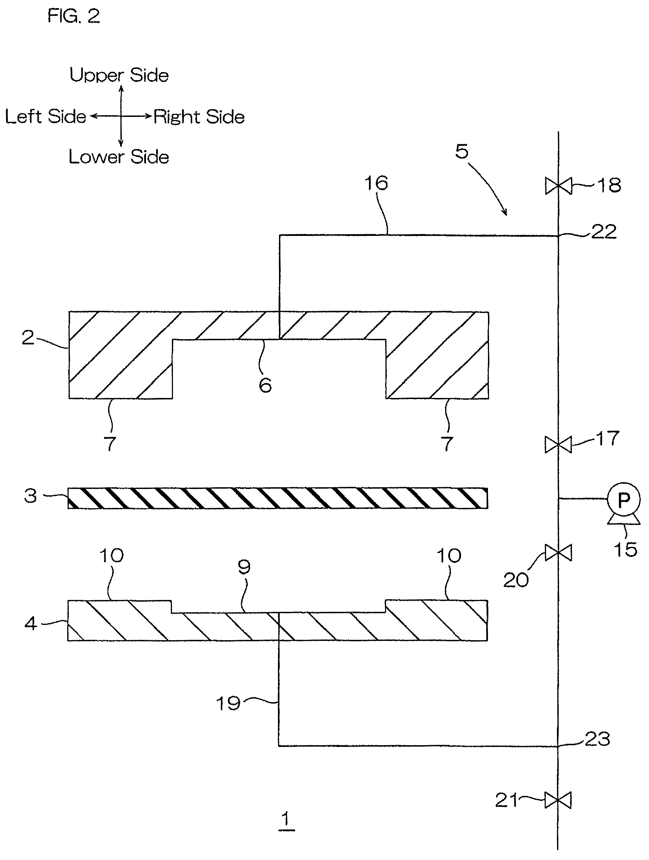

An encapsulating device as an embodiment of the adhering device of the present invention is described with reference to FIG. 1 and FIG. 2.

In FIG. 1, up-down directions on the plane of the sheet are referred to as "up-down directions" (thickness direction, first direction), the left-right directions on the plane of the sheet are referred to as "left-right directions" (second direction, direction perpendicular to the first direction), and the sheet thickness directions on the plane of the sheet are referred to as "front-back directions" (third direction, direction perpendicular to the first direction and the second direction). To be specific, the directions are in conformity with the direction arrows shown in FIG. 1. The directions in figures other than FIG. 1 are also based on the directions in FIG. 1.

In FIG. 1, the encapsulating device 1 is an encapsulating device for encapsulating an optical semiconductor element 52 as an electronic component with an encapsulating sheet 53 as a resin sheet. The encapsulating device 1 includes a first mold member 2, an elastic member 3, a second mold member 4, and a differential pressure generation device 5 as a differential pressure generation means.

As shown in FIG. 2, the first mold member 2 has a thick flat plate shape extending into the left-right directions and the front-back directions. To be specific, the first mold member 2 is formed into a generally rectangular shape when viewed from the top, front, and sides. The first mold member 2 is formed into a bottomed frame shape having a central portion upwardly dented, when viewed in front cross section and in side cross section. The first mold member 2 has the upwardly dented portion as a first cavity 6. The first cavity 6 is formed so that the first cavity 6 is dented upwardly from the lower face of the surrounding first frame portion 7 into a generally rectangular shape in the first mold member 2. The first cavity 6 is formed into a generally rectangular shape when viewed from the bottom. In this manner, the first cavity 6 is configured so that the first cavity 6 can contain an encapsulation preform 50 to be described later. The lower face of the first frame portion 7 is formed to be flat. The first mold member 2 includes, as necessary, a heater which is not shown.

The first mold member 2 has a size which is suitably set. To be specific, the first mold member 2 has a thickness of, for example, 20 mm or more, preferably 25 mm or more, and for example, 60 mm or less, preferably 50 mm or less; the maximum length of the first mold member 2 when viewed from the top is, for example, 200 mm or more, preferably 220 mm or more, and for example, 300 mm or less, preferably 280 mm or less. The first cavity 6 has a thickness of, for example, 6 mm or more, preferably 8 mm or more, and for example, 20 mm or less, preferably 18 mm or less, and the maximum length of the first cavity 6 when viewed from the bottom is, for example, 80 mm or more, preferably 100 mm or more, and for example, 200 mm or less, preferably 180 mm or less.

The first mold member 2 is formed from, for example, metals such as stainless steel, fiber-reinforced plastic such as glass epoxy, and hard materials such as glass, acrylic resin (to be specific, polymethyl methacrylate (PMMA), etc.), and silicone resin, and preferably, in view of visibility of the optical semiconductor element 52 and the encapsulating sheet 53, the first mold member 2 is formed from a hard transparent material.

The elastic member 3 is disposed below the first mold member 2 to face the first mold member 2, and is formed into a sheet extending in left-right directions and front-back directions. As shown in FIG. 1, the elastic member 3 is formed into a size that includes at least the first mold member 2 when projected in the thickness direction. To be specific, the peripheral end edge of the elastic member 3 is disposed at the same positions as those of the peripheral end edge of the first mold member 2.

The peripheral end portion of the upper face of the elastic member 3 is disposed adjacently so as to be in contact with the lower face of the first frame portion 7 in the up-down directions. Meanwhile, the center portion of the upper face of the elastic member 3 is disposed in spaced-apart relation in the up-down directions with the lower face (dented face) of the first cavity 6.

In this manner, the elastic member 3 is provided so that a first enclosed space 12 to be described later can be formed with the first cavity 6.

Examples of elastic materials that form the elastic member 3 include ethylene • propylene • diene rubber (EPDM); α-olefin • dicyclopentadiene such as 1-butene; a rubber copolymer having a non-conjugated double bond and a cyclic or non-cyclic polyene component such as ethylidenenorbornene; and various rubbers such as ethylene • propylene rubber, ethylene-propylene terpolymer, silicone rubber, polyurethane rubber, polyamide rubber, and nitrile rubber (e.g. NBR, etc.). Preferably, NBR is used.

The elastic member 3 has a tensile modulus at 25°C of, for example, 1.0 MPa or more, preferably 3.0 MPa or more, and for example, 15 MPa or less, preferably 13 MPa or less. The tensile modulus of the elastic member 3 within the above-described range allows for smooth elevation of the elastic member 3 (described later).

The elastic member 3 has a thickness of, for example, 0.5 mm or more, preferably 0.8 mm or more, and for example, 3.0 mm or less, preferably 2.0 mm or less.

The second mold member 4 is disposed below the elastic member 3 to face the elastic member 3. The second mold member 4 extends in the left-right directions and the front-back directions, and has a thinner flat-plate shape compared with the first mold member 2. To be specific, when viewed from the top, front, and sides, the second mold member 4 is formed into a generally rectangular shape. The second mold member 4 is formed into a bottomed frame shape having a central portion downwardly dented, when viewed in front cross section and in side cross section. The second mold member 4 has the downwardly dented portion as a second cavity 9. The second cavity 9 is formed so that the second cavity 9 is dented downwardly from the upper face of the surrounding second frame portion 10 into a generally rectangular shape in the second mold member 4. The upper face of the second frame portion 10 is formed to be flat. The second cavity 9 is formed into a generally rectangular shape when viewed from the top. The second cavity 9 is formed so that it overlaps with the projected plane of the first cavity 6 when projected in the thickness direction.

The shape of the second mold member 4 when viewed from the top is the same as the size of the encapsulating device 1 when viewed from the top. To be specific, the shapes of the first frame portion 7 and the second frame portion 10 when viewed from the top are the same, and the shapes of the first cavity 6 and the second cavity 9 when viewed from the top are the same. The second mold member 4 includes, as necessary, a heater which is not shown.

The second mold member 4 has a size which is suitably set, and the second mold member 4 has a thickness of, for example, 10 mm or more, preferably 20 mm or more, and for example, 60 mm or less, preferably 50 mm or less. The second cavity 9 has a thickness of, for example, 0.5 mm or more, preferably 1 mm or more, and for example, 20 mm or less, preferably 18 mm or less.

The second mold member 4 is formed from, for example, metals such as stainless steel, fiber-reinforced plastic such as glass epoxy, and hard materials such as glass, acrylic resin (to be specific, PMMA, etc.), and silicone resin.

The differential pressure generation device 5 includes a suction pump 15, a first pipe 16, a first vacuum valve 17, a first atmospheric air valve 18, a second pipe 19, a second vacuum valve 20, and a second atmospheric air valve 21.

The first pipe 16 is provided to connect the first mold member 2 with the suction pump 15. To be specific, one end portion (upstream end portion in the suction direction) of the first pipe 16 communicates with the first cavity 6 of the first mold member 2, and the other and portion (downstream end portion in the suction direction) of the first pipe 16 is connected to the suction pump 15. The first pipe 16 diverges therealong into branch pipes from a first branch portion 22. The branch pipe is configured to be open into atmospheric air. The first pipe 16 is formed from materials that are usually used for gas pipes, for example, from flexible hoses, and is formed to have a length that suitably ensures the distance from the suction pump 15 to the first mold member 2 (to be specific, for example, 5.0 cm or more, preferably 10 cm or more, and for example, 1000 cm or less, preferably 500 cm or less).

The first vacuum valve 17 is provided to be interposed along the first pipe 16, to be specific, provided between the suction pump 15 and the first branch portion 22 of the first pipe 16.

The first atmospheric air valve 18 is provided at the branch pipe of the first pipe 16.

The second pipe 19 is provided to connect the second mold member 4 with the suction pump 15. To be specific, one end portion (upstream end portion in the suction direction) of the second pipe 19 communicates with the second cavity 9 of the second mold member 4, and the other end portion (downstream end portion in the suction direction) of the second pipe 19 is connected to the suction pump 15. The other end portion of the second pipe 19 is configured as a common pipe with the other end portion of the first pipe 16. The second pipe 19 diverges therealong into branch pipes from a second branch portion 23. The branch pipe is configured to be open into atmospheric air. The second pipe 19 is formed from materials that are usually used for gas pipes, for example, from flexible hoses, and is formed to have a length that sufficiently ensures the distance from the suction pump 15 to the second mold member 4.

The second vacuum valve 20 is provided to be interposed along the second pipe 19, to be specific, provided between the suction pump 15 and the second branch portion 23 of the second pipe 19.

The second atmospheric air valve 21 is provided at the branch pipe of the second pipe 19.

Next, description is given below of assembly of the encapsulating device 1.

As shown in FIG. 2, first, the first mold member 2, the elastic member 3, and the second mold member 4 are prepared.

Then, the suction pump 15 and the first mold member 2 are connected through the first pipe 16, and the suction pump 15 and the second mold member 4 are connected through the second pipe 19.

Furthermore, the first mold member 2 and the second mold member 4 are allowed to face each other so that the first cavity 6 and the second cavity 9 face each other in the thickness direction. Then, the elastic member 3 is interposed between the first mold member 2 and the second mold member 4. That is, the first mold member 2 is disposed above the second mold member 4 with the elastic member 3 interposed therebetween. In this manner, the second cavity 9 is disposed to face the first cavity 6 with the elastic member 3 interposed therebetween.

Then, the peripheral end portion of the elastic member 3 is sandwiched in the thickness direction between the first frame portion 7 and the second frame portion 10. The first frame portion 7 and the second frame portion 10 can also be sandwiched in the thickness direction by, for example, a cramp member such as a clip which is not shown.

In this manner, the first enclosed space 12 is formed with the first cavity 6 and the elastic member 3. The first enclosed space 12 is formed by defining the space defined by the first cavity 6 with the elastic member 3 from the bottom, and is formed into a shape that corresponds to the first cavity 6. The lower face of the first frame portion 7 and the upper face of the peripheral end portion of the elastic member 3 are in close contact so that air can be shut down from going in or going out from therebetween.

Meanwhile, a second enclosed space 13 is formed with the second cavity 9 and the elastic member 3. The second enclosed space 13 encloses the space opposite to the first enclosed space 12 relative to the elastic member 3. To be specific, the second enclosed space 13 is formed by defining the space defined by the second cavity 9 with the elastic member 3 from above. That is, the second enclosed space 13 is formed into a shape that corresponds to the second cavity 9. The upper face of the second frame portion 10 and the lower face of the peripheral end portion of the elastic member 3 are in close contact so that air can be shut down from going in or going out from therebetween.

As shown in FIG. 1, the first mold member 2 and the elastic member 3 are configured so that the lower face (dented face) of the first cavity 6 and the upper face of the peripheral end portion of the elastic member 3 are substantially parallel.

Next, description is given below of a method for producing an optical semiconductor device 51 using the encapsulating device 1 with reference to FIG. 1 to FIG. 4.

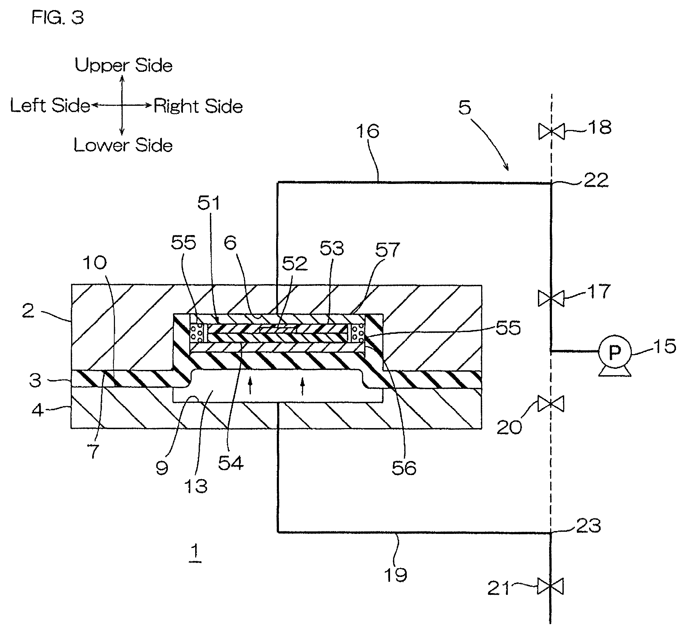

The method is a method for producing an optical semiconductor device 51 by encapsulating an optical semiconductor element 52 with an encapsulating sheet 53. The method includes a placement step (ref: FIG. 1 and FIG. 2), in which an encapsulation preform 50 is placed in the first enclosed space 12 of the encapsulating device 1; and an encapsulating step (an example of an adhering step, ref: FIG. 3), in which the air pressure of the first enclosed space 12 is made lower than the air pressure of the second enclosed space 13 by operating a differential pressure generation device 5.

### [Placement step]

In the placement step, to place the encapsulation preform 50 in the first enclosed space 12, first, for example, as shown in FIG. 1, the encapsulation preform 50 is prepared.

The encapsulation preform 50 includes a first support plate 56, a second support plate 57, a spacer 55, a board 54 on which an optical semiconductor element 52 is mounted, and an encapsulating sheet 53.

The first support plate 56 is formed into a flat plate shape extending in the left-right directions and the front-back directions. The first support plate 56 is formed into a generally rectangular shape or a generally circular shape when viewed from the top. The first support plate 56 is not particularly limited, and is formed from, for example, a hard material such as acrylic resin (to be specific, PMMA, etc.) and silicone resin. The size of the first support plate 56 when viewed from the top is smaller than the size of the first cavity 6 when viewed from the top, or is set to be the same. The first support plate 56 has a thickness of, for example, 0.1 mm or more, preferably 0.5 mm or more, and for example, 10 mm or less, preferably 5 mm or less.

The second support plate 57 is disposed above the first support plate 56 and to face the first support plate 56 in spaced-apart relation. The second support plate 57 is formed into the same shape and the size with the first support plate 56 when viewed from the top. The second support plate 57 is formed from, for example, metals such as stainless steel, fiber-reinforced plastic such as glass epoxy, and hard materials such as glass, acrylic resin (to be specific, polymethyl methacrylate (PMMA), etc.), and silicone resin, and preferably, in view of clearly seeing the optical semiconductor element 52 and the encapsulating sheet 53, the second support plate 57 is formed from a hard transparent material.

The spacer 55 is provided to be interposed between the peripheral end portion of the first support plate 56 and the peripheral end portion of the second support plate 57, and is formed into a generally frame shape or a generally circular when viewed from the top. The spacer 55 is formed so as to be extendable in the up-down directions (the thickness direction of the first support plate 56 and the second support plate 57). Examples of the spacer 55 include rubber foam of urethane rubber foam. The thickness of the spacer 55, to be specific, the thickness of the spacer 55 before pressing (described later) of the first support plate 56 and the second support plate 57 is set to be larger than the total thickness of the optical semiconductor element 52, the board 54, and the encapsulating sheet 53 to be described next. The maximum thickness of the spacer 55 when viewed from the top is, for example, 1 mm or more, preferably 10 mm or more, and for example, 150 mm or less, preferably 100 mm or less.

The board 54 is made of an insulating board of, for example, a laminate board in which an insulating layer is laminated on, for example, a silicon board, a ceramic board, a polyimide resin board, and a metal board.

On top of the board 54, a conductive pattern (not shown) including an electrode (not shown) for being electrically connected to a terminal (not shown) of the optical semiconductor element 52 to be described next, and a wire that is continuous thereto is formed. The conductive pattern is formed of a conductor such as gold, copper, silver, and nickel.

The shape of the board 54 when viewed from the top is not particularly limited. For example, the shape of the board 54 when viewed from the top can be a generally rectangular shape or a generally circular shape. The size of the board 54 when viewed from the top is selected suitably. To be specific, the size of the board 54 when viewed from the top is set smaller than the first support plate 56 and the second support plate 57. To be specific, the maximum length of the encapsulating sheet 53 when viewed from the top is, for example, 1 mm or more, preferably 5 mm or more, and for example, 200 mm or less, preferably 150 mm or less. The board 54 has a thickness of, for example, 100 µm or more, preferably 500 µm or more, and for example, 5000 µm or less, preferably 3000 µm or less.

The optical semiconductor element 52 is an optical semiconductor element that converts electric energy into light energy, and is formed, for example, into a generally rectangular shape having a thickness smaller than the length of the surface direction (length in perpendicular direction to the thickness direction) viewed in cross section.

Examples of the optical semiconductor element 52 include LEDs (light-emitting diode element) such as blue LED that emits blue light, and LD (laser diode). The size of the optical semiconductor element 52 is suitably set in accordance with application and purposes. To be specific, the optical semiconductor element 52 has a thickness of, for example, 10 to 1000 µm, the maximum length when viewed from the top of, for example, 0.01 mm or more, preferably 0.1 mm or more, and for example, 20 mm or less, preferably 15 mm or less.

The optical semiconductor element 52 is, for example, flip-chip mounted on the board 54, or connected by wire bonding.

The board 54 is supported by the first support plate 56. To be specific, the lower face of the board 54 (face opposite to the upper face where the optical semiconductor element 52 is mounted) is placed on the upper face of the first support plate 56. In other words, the first support plate 56 is disposed on the opposite side to the optical semiconductor element 52 side relative to the board 54, that is, disposed below the board 54.

The encapsulating sheet 53 is disposed above the board 54 and to face the board 54 where the optical semiconductor element 52 is mounted in spaced-apart relation. The encapsulating sheet 53 has a shape of a sheet extending in the left-right directions and the front-back directions, and the shape of the encapsulating sheet 53 when viewed from the top is not particularly limited, and for example, is a generally rectangular shape or a generally circular shape when viewed from the top. To be specific, the encapsulating sheet 53 is formed, when projected in the thickness direction, to be included in the projected plane of the board 54. The size of the encapsulating sheet 53 when viewed from the top is selected suitably. To be specific, the size of the encapsulating sheet 53 is set to be smaller than the first support plate 56 and the second support plate 57, and to be specific, the maximum length of the board 54 when viewed from the top is, for example, 1 mm or more, preferably 5 mm or more, and for example, 200 mm or less, preferably 150 mm or less. The encapsulating sheet 53 has a thickness of, for example, 10 µm or more, preferably 50 µm or more, and for example, 2000 µm or less, preferably 1000 µm or less.

The encapsulating material that forms the encapsulating sheet 53 contains, for example, a B-STAGE curable resin.

That is, the curable resin is a two-step curable resin having, for example, a two-step reaction scheme: in the first step reaction, the resin is brought into B-stage (semi-cured), and in the second step reaction, the resin is brought into C-stage (completely cured). The above-described encapsulating material is the above-described curable resin that has been brought into B-STAGE.

Examples of the two-step curable resin include a two-step curable thermosetting resin that is cured by heat, and a two-step curable activation energy-ray curable resin that is cured by application of activation energy-ray (e.g. ultraviolet ray, electron beam, etc.).

To be specific, examples of the two-step curable resin include silicone resin, epoxy resin, polyimide resin, phenol resin, urea resin, melamine resin, and unsaturated polyester resin.

The encapsulating material can also contain a phosphor and/or a filler.

The phosphor has a wavelength conversion function. Examples thereof include a yellow phosphor that is capable of converting blue light into yellow light, and a red phosphor that is capable of converting blue light into red light.

Examples of the yellow phosphor include a silicate phosphor such as (Ba,Sr,Ca)₂SiO₄: Eu, (Sr,Ba)₂SiO₄: Eu (barium orthosilicate (BOS)); a garnet type phosphor having a garnet type crystal structure such as Y₃Al₅O₁₂: Ce (YAG (yttrium • aluminum garnet): Ce), Tb₃Al₃O₁₂: Ce (TAG (terbium • aluminum garnet): Ce); and an oxynitride phosphor such as Ca-α-SiAlON.

Examples of the red phosphor include a nitride phosphor such as CaAlSiN₃: Eu, CaSiN₂: Eu.

Examples of a shape of the phosphor include a sphere shape, a plate shape, and a needle shape. Preferably, in view of fluidity, a sphere shape is used.

The average value of the maximum length (when spherical, the average particle size) of the phosphor is, for example, 0.1 µm or more, preferably 1 µm or more, and for example, 200 µm or less, preferably 100 µm or less.

The phosphor can be used singly, or may be used in combination.

The mixing ratio of the phosphor relative to 100 parts by mass of the curable resin is, for example, 0.1 parts by mass or more, preferably 0.5 parts by mass or more, and for example, 80 parts by mass or less, preferably 50 parts by mass or less.

Examples of the filler include organic microparticles such as silicone particles (to be specific, including silicone rubber particles), and inorganic microparticles such as silica (e.g. fumed silica, etc.), talc, alumina, aluminum nitride, and silicon nitride. The average value of the maximum length (when spherical, the average particle size) of the filler is, for example, 0.1 µm or more, preferably 1 µm or more, and for example, 200 µm or less, preferably 100 µm or less. The filler may be used singly, or may be used in combination. The mixing ratio of the filler relative to 100 parts by mass of the curable resin is, for example, 0.1 parts by mass or more, preferably 0.5 parts by mass or more, and for example, 70 parts by mass or less, preferably 50 parts by mass or less.

The encapsulating sheet 53 is formed in B-STAGE state.

The encapsulating sheet 53 has a compressive modulus at 25°C of, for example, 0.040MPa or more, preferably 0.050MPa or more, more preferably 0.075MPa or more, even more preferably 0.100MPa or more, and for example, 0.145MPa or less, preferably 0.140MPa or less, more preferably 0.135MPa or less, even more preferably 0.125MPa or less.

The encapsulating sheet 53 is supported by the second support plate 57, and to be specific, the upper face of the encapsulating sheet 53 (face opposite to the lower face where the optical semiconductor element 52 is embedded) is allowed to adhere to the lower face of the second support plate 57. The second support plate 57 is disposed on the opposite side to the board 54 relative to the encapsulating sheet 53, that is, disposed above the encapsulating sheet 53.

To prepare the encapsulation preform 50, first, the first support plate 56 is prepared, and then the board 54 on which the optical semiconductor element 52 is mounted is placed at the center of the first support plate 56, and a spacer 55 is placed on the peripheral end portion of the first support plate 56, or the first support plate 56 at the surrounding of the board 54 on which the optical semiconductor element 52 is mounted. Separately, the encapsulating sheet 53 is temporary attached to the second support plate 57, and the peripheral end portion of the second support plate 57 is placed on the upper face of the spacer 55 so that the encapsulating sheet 53 faces the board 54.

Thereafter, the prepared encapsulation preform 50 is placed on the first enclosed space 12.

To be specific, first, the elastic member 3 is brought into contact with the second frame portion 10 of the second mold member 4. In this manner, the second enclosed space 13 is formed.

Then, the encapsulation preform 50 is placed on the elastic member 3. To be specific, the first support plate 56 of the encapsulation preform 50 is placed at the center of the elastic member 3. In this manner, the optical semiconductor element 52, the board 54, and the encapsulating sheet 53 are disposed to face and above the second mold member 4 with the elastic member 3 interposed therebetween.

Thereafter, the first mold member 2 is disposed to face the second mold member 4 so as to cover the encapsulation preform 50. To be specific, the first mold member 2 is placed on the elastic member 3 so that the elastic member 3 is sandwiched in the thickness direction between the first frame portion 7 of the first mold member 2 and the second frame portion 10 of the second mold member 4, and that the first cavity 6 of the first mold member 2 contains the encapsulation preform 50.

In this manner, the first enclosed space 12 is formed, and the encapsulation preform 50 is placed in the first enclosed space 12.

Thereafter, the first frame portion 7 and the second frame portion 10 are sandwiched in the thickness direction by a cramp member which is not shown.

### [Encapsulating Step]

The encapsulating step is performed after the placement step.

The encapsulating step includes a decompression step, a differential pressure generation step, and a retrieve step.

### <Decompression Step>

In the decompression step, to be specific, first, as shown in the broken line in FIG. 1, the first atmospheric air valve 18 and the second atmospheric air valve 21 are closed, and as shown in the bold line in FIG. 1, the first vacuum valve 17 and the second vacuum valve 20 are opened. In this manner, the first enclosed space 12 is allowed to communicate with the suction pump 15 through the first pipe 16 and the first vacuum valve 17. The second enclosed space 13 is in communication with the suction pump 15 through the second pipe 19 and the second vacuum valve 20. The suction pump 15 is operated with the above state. In this manner, the air pressure P1 of the first enclosed space 12 and the air pressure P2 of the second enclosed space 13 are both decreased. The air pressure P1 and air pressure P2 are the same, and for example, are 10 hPa or less, preferably 5 hPa or less, more preferably 3 hPa or less, and for example, 0.01 hPa or more.

The above-described air pressure P1 and air pressure P2 are the same, and therefore the elastic member 3 does not move in the thickness direction and stands still, as shown in FIG. 1 (at the position placed).

### <Differential pressure generation step>

The differential pressure generation step is performed after the decompression step.

In the differential pressure generation step, differential pressure generation device 5 is operated so that the air pressure P1 of the first enclosed space 12 is lower than the air pressure P2 of the second enclosed space 13.

To be specific, as shown in FIG. 3, the second vacuum valve 20 is closed and the second atmospheric air valve 21 is opened. In this manner, the second enclosed space 13 is open to the air through the second pipe 19 and the second atmospheric air valve 21. Thus, the air pressure P2 of the second enclosed space 13 is allowed to be the atmospheric pressure. Then, the air pressure P1 of the first enclosed space 12 (ref: FIG. 1) is allowed to be lower than the air pressure P2 of the second enclosed space 13. That is, a differential pressure is generated between the first enclosed space 12 and the second enclosed space 13. Thus, the center portion of the elastic member 3 moves to the first cavity 6 side, that is, upward, so as to decrease the volume of the first enclosed space 12. That is, the center portion of the elastic member 3 is elevated (goes up).

To be specific, in the elastic member 3, the portion where the elastic member 3 faces the first support plate 56 elevates, as shown with the arrows in FIG. 3, so as to press the first support plate 56 upwardly. Along with the elevation (going up) of the first support plate 56, the second support plate 57 is brought into contact with the lower face of the first cavity 6 (dented face), and furthermore, the first support plate 56 presses the second support plate 57, and then the length (thickness) in the up-down direction of the spacer 55 decreases. In this manner, the encapsulating sheet 53 and the board 54 are pressed in the thickness direction by the first support plate 56 and the second support plate 57.

In the elastic member 3, the portion where the elastic member 3 is exposed from the first support plate 56 fills the gap formed with, as shown in FIG. 3, the first support plate 56 and the second support plate 57, and the side face of the first cavity 6. In this manner, the first enclosed space 12 substantially disappears.

In this manner, the encapsulation preform 50 is pressed in the up-down directions, and then the optical semiconductor element 52 is embedded in the encapsulating sheet 53.

At the same time with the embedment of the optical semiconductor element 52 with the encapsulating sheet 53, or thereafter, the encapsulating sheet 53 is brought into C stage. For example, when the encapsulating sheet 53 contains a two-step curable thermosetting resin that is in B-STAGE, a heater (not shown) included in the first mold member 2 and the second mold member 4 heats the encapsulating sheet 53. Alternatively, when the encapsulating sheet 53 contains a two-step curable activation energy-ray curable resin that is in B-STAGE, ultraviolet ray is applied to the encapsulating sheet 53 using an ultraviolet ray lamp which is not shown.

In this manner, the optical semiconductor device 51 including the board 54, the optical semiconductor element 52 mounted on the board 54, and the encapsulating sheet 53 that encapsulates the optical semiconductor element 52 is produced.

### [Retrieve step]

The retrieve step is performed after the differential pressure generation step.

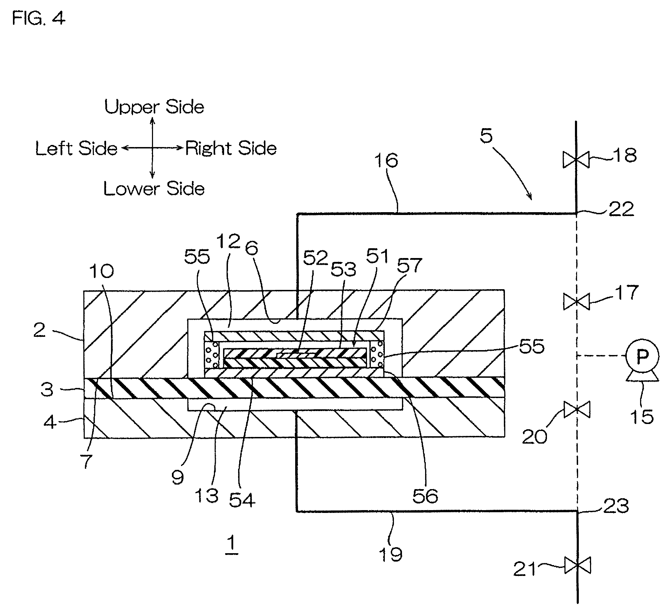

In the retrieve step, as shown in FIG. 4, the first vacuum valve 17 is closed (ref: broken line), and the first atmospheric air valve 18 is opened (ref: bold line). In this manner, the first enclosed space 12 is open to the air through the first pipe 16 and the first atmospheric air valve 18. Therefore, the air pressure P1 of the first enclosed space 12 is allowed to be the atmospheric pressure, and becomes the same as the air pressure P2 of the second enclosed space 13. Then, the elastic member 3 moves to the second cavity 9 side. That is, the elastic member 3 descends (goes down) to the placement position. In this manner, pressing of the first support plate 56 and the second support plate 57 is released, extending the spacer 55 to the original thickness. The encapsulating sheet 53 is allowed to adhere to the board 54 and the optical semiconductor element 52, and this causes the encapsulating sheet 53 to be spaced apart from the second support plate 57.

Thereafter, the cramp member, which is not shown, is removed from the first frame portion 7 and the second frame portion 10, and then the second mold member 4 is withdrawn from the elastic member 3.

Thereafter, the second support plate 57 of the encapsulation preform 50 is withdrawn from the spacer 55, and the optical semiconductor device 51 is retrieved. In this manner, the optical semiconductor device 51 is obtained.

With the encapsulating device 1, in which the first mold member 2, the elastic member 3, the differential pressure generation device 5 are included, the structure of the encapsulating device 1 can be made simple, and therefore the encapsulating device 1 can be made small.

That is, a conventional flat-plate pressing device includes two pressing plates (mold), and a pressure application source for applying a pressure to these; the pressure application source is configured from, for example, a large crank structure and is provided so as to be connected to the pressing plate near the pressing plate. Therefore, the flat-plate pressing device is large.

In contrast with such a conventional flat-plate pressing device, in the encapsulating device 1, the first pipe 16 and the second pipe 19 are adjusted to be a suitable length, and the suction pump 15 can be disposed with a high degree of flexibility, relatively far from the first mold member 2 and the second mold member 4. Therefore, the encapsulating device 1 can be made smaller.

That is, in the encapsulating device 1, the first mold member 2, the elastic member 3, and the second mold member 4, and the differential pressure generation device 5 can be separately configured, and therefore the first mold member 2, the elastic member 3, and the second mold member 4, and the differential pressure generation device 5 can be individually disposed to achieve a small size. Therefore, the encapsulating device 1 can achieve small size members, and excellent transportability. Then, when using the encapsulating device 1, the first mold member 2 is connected with the suction pump 15 through the first pipe 16, and the second mold member 4 is connected with the suction pump 15 through the second pipe 19, thereby forming the encapsulating device 1.

Furthermore, the first mold member 2, the elastic member 3, and the second mold member 4 can be made into a unit, and the unit and the differential pressure generation device 5 can be transported as a set. When using the encapsulating device 1, the unit and the differential pressure generation device 5 can be individually disposed.

With the encapsulating device 1, by operating the differential pressure generation device 5, the elastic member 3 moves to the first cavity 6 side. Therefore, by pressing the encapsulation preform 50 towards the direction facing the optical semiconductor element 52 and the encapsulating sheet 53, that is, in the thickness direction (up-down direction), the optical semiconductor element 52 can be reliably encapsulated with the encapsulating sheet 53.

In the encapsulating device 1, the first mold member 2 and the second support plate 57 are formed from a transparent material. That is, the configuration can allow us to see the optical semiconductor element 52 and the encapsulating sheet 53 from above and/or sides. Therefore, the status of the encapsulation of the optical semiconductor element 52 and the encapsulating sheet 53 can be visually checked through the first mold member 2 and the second support plate 57 from above and/or sides.

Furthermore, in the encapsulating device 1, the second mold member 4 includes a second cavity 9 that can form the second enclosed space 13, and therefore by ensuring that the air pressure P2 of the second enclosed space 13 is higher than the air pressure P1 of the first enclosed space 12 with the second cavity 9, the elastic member 3 can be reliably moved towards the first cavity 6 side.

Furthermore, in the encapsulating device 1, the first support plate 56 and the second support plate 57 ensure holding of the encapsulation attitude of the board 54 on which the optical semiconductor element 52 is mounted and of the encapsulating sheet 53, respectively. To be specific, horizontal attitude of the board 54 and the encapsulating sheet 53 can be held reliably. Therefore, the optical semiconductor element 52 can be encapsulated with the encapsulating sheet 53 precisely.

Furthermore, with the above-described method, by operating the differential pressure generation device 5 in the encapsulating step, the air pressure P1 of the first enclosed space 12 is set lower than the air pressure P2 of the second enclosed space 13 to move the elastic member 3 towards the first cavity 6 side, and therefore, the encapsulation preform 50 is pressed in the direction facing the optical semiconductor element 52 and the encapsulating sheet 53, that is, in the thickness direction (up-down direction), thereby ensuring the encapsulation of the optical semiconductor element 52 with the encapsulating sheet 53.

Thus, with the simple method of setting the air pressure P1 of the first enclosed space 12 lower than the air pressure P2 of the second enclosed space 13, the optical semiconductor element 52 can be reliably encapsulated with the encapsulating sheet 53.

Furthermore, with the method, after decreasing the pressure of both of the first enclosed space 12 and the second enclosed space 13 in the decompression step as shown in FIG. 1, atmospheric air is introduced into the second enclosed space 13 in the differential pressure generation step as shown in FIG. 3, allowing the air pressure P2 of the second enclosed space 13 to be the atmospheric pressure. Thus, the air pressure P1 of the first enclosed space 12 can be rapidly set lower than the air pressure P2 of the second enclosed space 13.

That is, to be specific, as shown in FIG. 3, by opening the second atmospheric air valve 21 at once, the atmospheric air can be introduced instantly from the second atmospheric air valve 21, the first branch portion 22, and the second pipe 19.

Thus, the elastic member 3 can be rapidly moved towards the first cavity 6 side, that is, the elastic member 3 can be elevated (go up) at once and the optical semiconductor element 52 can be encapsulated with the encapsulating sheet 53 efficiently.

### (Variation)

In the following, those members that are the same as those in the embodiment of FIG. 1 to FIG. 4 are given the same reference numerals, and detailed descriptions thereof are omitted.

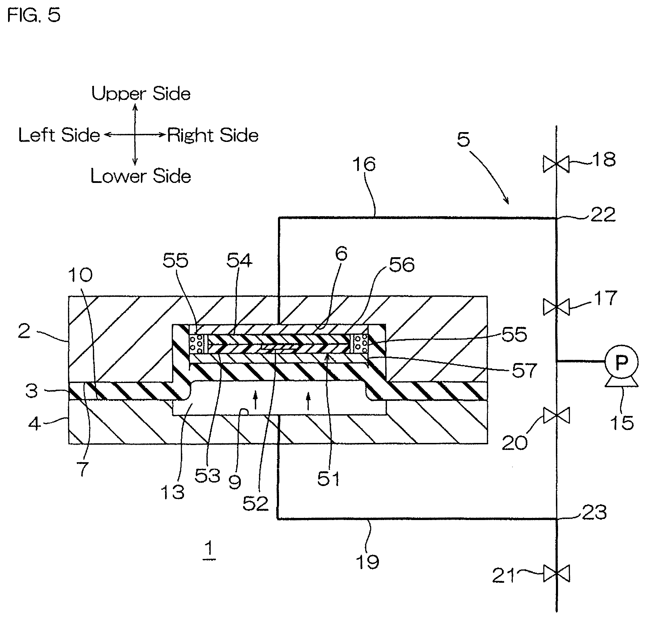

As shown in FIGs. 1 and 3, the encapsulating sheet 53 is disposed above the board 54 on which the optical semiconductor element 52 is mounted, and the encapsulating sheet 53 covers the upper face and the side faces of the optical semiconductor element 52. However, the encapsulating sheet 53, and the board 54 on which the optical semiconductor element 52 is mounted can be disposed without limitation to the above. For example, as shown in FIG. 5, the encapsulating sheet 53 can be also disposed below the board 54 on which the optical semiconductor element 52 is mounted, and then the encapsulating sheet 53 can cover the lower face and the side faces of the optical semiconductor element 52.

The second support plate 57 is placed at the center portion of the elastic member 3, and on the upper face of the second support plate 57, the lower face of the encapsulating sheet 53 is temporary adhered.

Furthermore, a hard material other than the transparent material can also be used for the second support plate 57.

Meanwhile, the board 54 is temporary adhered to the first support plate 56.

The upper face of the first support plate 56 is brought into contact with the lower face (dented face) of the first cavity 6 in the encapsulating step, to be specific, when the center portion of the elastic member 3 is elevated.

The first support plate 56 is preferably formed from a transparent material such as glass, acrylic resin, and silicone resin (to be specific, PMMA, etc.), in view of clearly seeing the optical semiconductor element 52 and the encapsulating sheet 53.

The embodiment of FIG. 5 also achieves the same operations and effects of the embodiment of FIG. 1 to FIG. 4.

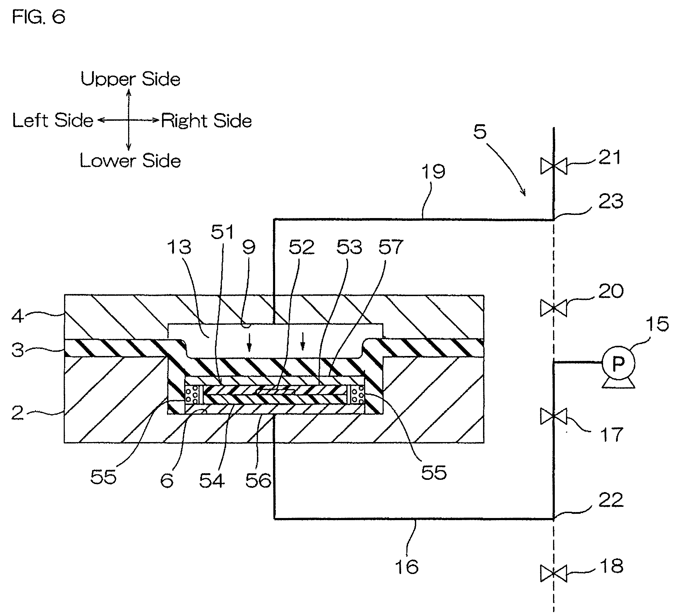

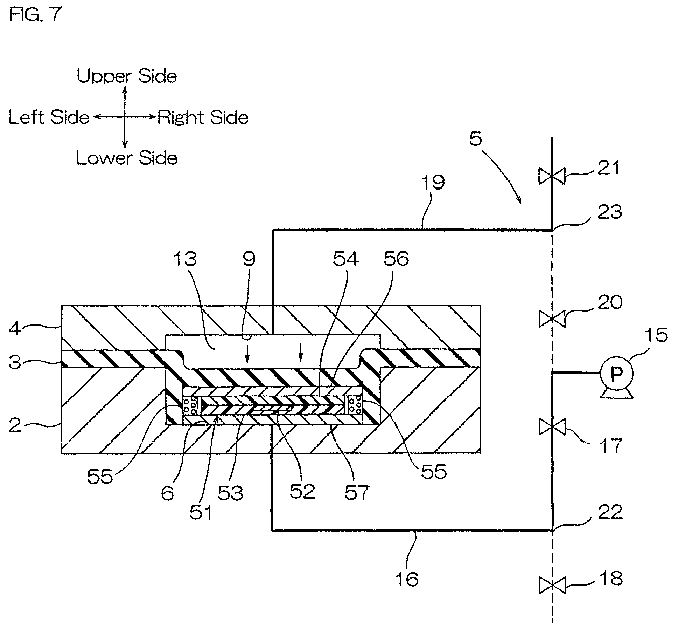

In the embodiment of FIG. 1 to FIG. 5, the second mold member 4 is disposed below the first mold member 2. However, for example, as shown in FIGs. 6 and 7, the second mold member 4 can also be disposed above the first mold member 2.

In the embodiments of FIG. 6 and FIG.7, a differential pressure is generated by which the air pressure P1 of the first enclosed space 12 (not shown in FIGs. 6 and 7, ref: FIG. 1) is allowed to be lower than the air pressure P2 of the second enclosed space 13 in the differential pressure generation step, causing the elastic member 3 to move toward the lower side. That is, the center portion of the elastic member 3 descends (goes down).

In the embodiment of FIG. 6, the encapsulating sheet 53 is disposed above the board 54 on which the optical semiconductor element 52 is mounted in the differential pressure step, and the encapsulating sheet 53 covers the top face and the side faces of the optical semiconductor element 52.

Meanwhile, in the embodiment of FIG. 7, the encapsulating sheet 53 is disposed below the board 54 on which the optical semiconductor element 52 is mounted in the differential pressure step, and the encapsulating sheet 53 covers the lower face and the side faces of the optical semiconductor element 52.

The embodiments of FIG. 6 and FIG. 7 also achieve the same operations and effects as those of FIG. 1 to FIG. 5.

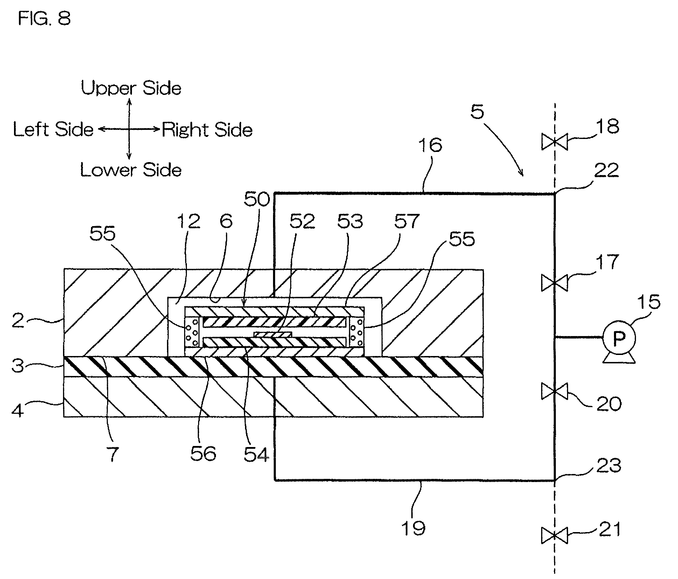

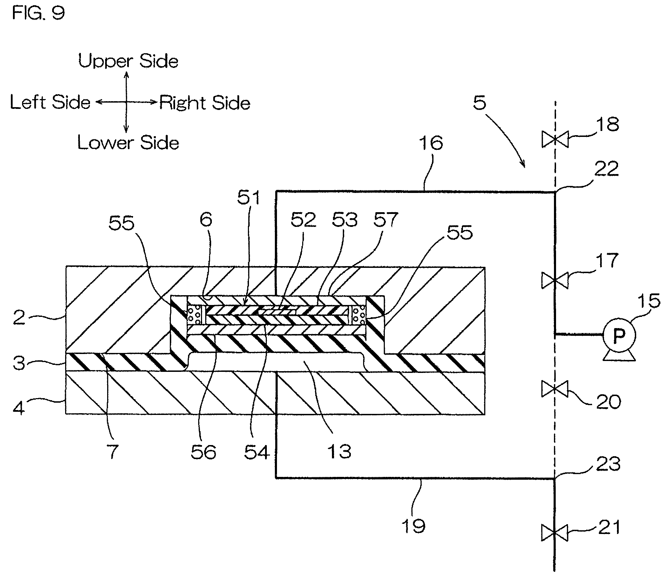

In the embodiments of FIG. 1 to FIG. 7, the second cavity 9 is formed in advance in the second mold member 4. However, for example, as shown in FIGs. 8 and 9, the second mold member 4 can also be formed into a flat plate shape.

In FIGs. 8 and 9, the top face of the second mold member 4 is formed into a flat face.

The use of the second mold member 4 as well achieves formation of the first enclosed space 12 (ref: FIG. 8) and the second enclosed space 13 (ref: FIG. 9), and at the same time a differential pressure by which the air pressure P1 of the first enclosed space 12 is allowed to be lower than the air pressure P2 of the second enclosed space 13 is caused in the first enclosed space 12 (ref: FIG. 8) and the second enclosed space 13 (ref: FIG. 9), in the decompression step (ref: FIG. 8) and the differential pressure generation step (ref: FIG. 9).

The embodiments of FIG. 8 and FIG.9 also achieve the same operations and effects as those of FIG. 1 to FIG. 7. Furthermore, in the embodiments of FIG. 8 and FIG.9, without forming the second cavity 9 in the second mold member 4, the top face thereof is formed to be flat, and therefore the configuration of the encapsulating device 1 can be made more simple.

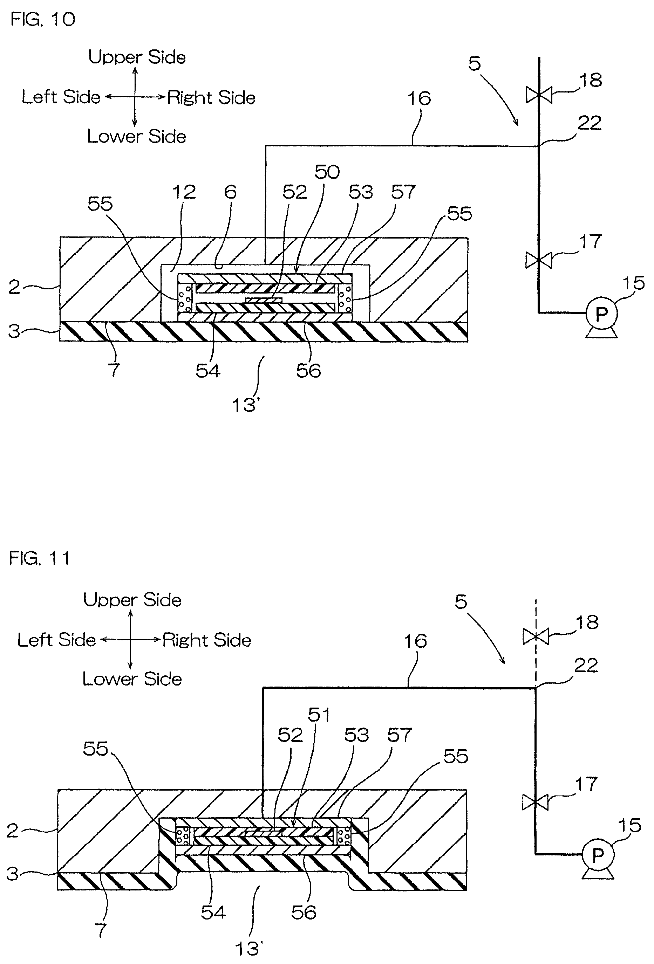

Furthermore, in the embodiments of FIG. 1 to FIG. 9, the second mold member 4 is provided in the encapsulating device 1. However, for example, as shown in FIGs. 10 and 11, the encapsulating device 1 can be configured without providing the second mold member 4 in the encapsulating device 1.

As shown in FIGs. 10 and 11, the elastic member 3 is provided below the encapsulating device 1, and the lower face of the elastic member 3 is exposed. The peripheral end portion of the elastic member 3 is disposed so as to be in contact with the first frame portion 7 of the first mold member 2.

The space opposite to the first enclosed space 12 relative to the elastic member 3 is an open space 13'.

The differential pressure generation device 5 does not include the second pipe 19, the second vacuum valve 20, and the second atmospheric air valve 21.

The encapsulating step in this method does not include the above-described decompression step, and before the differential pressure generation step, first, as shown in FIG. 10, the first atmospheric air valve 18 and the first vacuum valve 17 are opened, and at the same time, the suction pump 15 is operated.

At this time, the first enclosed space 12 is in communication with the suction pump 15 through the first vacuum valve 17, and also is open to the air through the first atmospheric air valve 18, and therefore the air pressure P1 of the first enclosed space 12 maintains the atmospheric pressure without decreasing the pressure.

Then, in the differential pressure generation step, as shown in FIG. 11, the first atmospheric air valve 18 is closed. Then, the first enclosed space 12 is in communication with the suction pump 15 only through the first vacuum valve 17, and therefore the air pressure P1 of the first enclosed space 12 is decreased. That is, the air pressure P1 of the first enclosed space 12 is allowed to be lower than the air pressure P2 of the open space 13', that is, becomes lower than the atmospheric pressure. Then, the elastic member 3 is elevated (goes up). In this manner, the encapsulation preform 50 is pressed in the thickness direction, and the optical semiconductor element 52 is encapsulated with the encapsulating sheet 53.

The embodiments of FIG. 10 and FIG. 11 as well achieve the same operations and effects as those of FIG. 1 to FIG. 9. Furthermore, in the embodiments of FIG. 10 and FIG.11, the encapsulating device 1 does not include the second mold member 4, and therefore the configuration of the encapsulating device 1 can be made more simple.

Although not shown, in the embodiments of FIG. 1 to FIG. 9, in the decompression step and the differential pressure generation step, the pressure in the first enclosed space 12 is decreased using the suction pump 15. However, instead of the suction pump 15, a pressure can also be applied to the second enclosed space 13 using, for example, a pressure device such as a compressor using air.

Furthermore, the encapsulation preform 50 includes the first support plate 56 and the second support plate 57 in the embodiments of FIG. 1 to FIG. 11. However, although not shown, the configuration of the encapsulation preform 50 can also be as follows: only one of the first support plate 56 and the second support plate 57 is provided, or both of these are provided.

The spacer 55 is provided in the encapsulation preform 50 in the embodiments of FIG. 1 to FIG. 11. However, without limitations, although not shown, the encapsulation preform 50 can also be configured without providing the spacer 55.

In the embodiments of FIG. 1 to FIG. 11, the adhering device of the present invention is described as an encapsulating device 1 for encapsulating the optical semiconductor element 52 with the encapsulating sheet 53. However, without limitation, for example, as shown in FIG. 1, it can be an adhering device 1 for adhering the electronic component 52 with the resin sheet 53. Furthermore, the adhering device of the present invention can also be an adhering device 1 for adhering, as shown in FIG. 1, the electronic component 52 to other members 57 with the resin sheet 53. In this case, the resin sheet 53 is sandwiched between the electronic component 52 and other members 57 in the thickness direction.

The electronic component 52 includes the optical semiconductor element 52 and semiconductor elements other than that, and also includes, for example, a condenser.

The resin sheet 53 can contain, as a filler, pigment such as carbon black at a suitable ratio.

In the adhering device 1, as shown in FIG. 1, in the placement step, an adhering preform 50 is placed. The adhering preform 50 includes a board 54 on which the electronic component 52 is mounted.

While the illustrative embodiments of the present invention are provided in the above description, such is for illustrative purpose only and it is not to be construed as limiting in any manner. Modification and variation of the present invention that will be obvious to those skilled in the art is to be covered by the following claims.

### Industrial Applicability

The adhering device is used as an encapsulating device.

### Reference Signs List

- 1: encapsulating device (adhering device)
- 2: first mold member
- 3: elastic member
- 4: second mold member
- 5: differential pressure generation device
- 6: first cavity
- 12: first enclosed space
- 13: second enclosed space
- 13': open space
- 50: encapsulation preform (adhering preform)
- 52: optical semiconductor element (electronic component)
- 53: encapsulating sheet (resin sheet)
- 54: board
- 56: first support plate
- 57: second support plate
- P1: air pressure (of first enclosed space)
- P2: air pressure (of second enclosed space)

## Claims

1. An adhering device for adhering a resin sheet to an electronic component, comprising
a first mold member having a first cavity in which an adhering preform can be accommodated, the adhering preform including the electronic component and the resin sheet disposed to face the electronic component in spaced-apart relation,
an elastic member disposed to face the resin sheet so that a first enclosed space can be formed with the first cavity, and
a differential pressure generation means connected to the first mold member for allowing the air pressure of the first enclosed space to be lower than the air pressure of a space opposite to the first enclosed space relative to the elastic member,
wherein the adhering device is configured so that by operating the differential pressure generation means, the elastic member moves towards the first cavity side, and therefore, the adhering preform is pressed in the direction facing the electronic component and the resin sheet, thereby adhering the resin sheet to the electronic component.

2. The adhering device according to Claim 1, wherein the first mold member and the elastic member are provided separately from the differential pressure generation means.

3. The adhering device according to Claim 1, wherein the first mold member is configured so that the electronic component and/or the resin sheet are visible.

4. The adhering device according to Claim 1, comprising a second mold member disposed to face the first mold member with the elastic member sandwiched therebetween,
wherein the second mold member has a second cavity facing the first cavity with the elastic member sandwiched therebetween and capable of forming a second enclosed space, the second enclosed space enclosing, with the elastic member, the space opposite to the first enclosed space relative to the elastic member.

5. The adhering device according to Claim 1, wherein the adhering perform comprises a board on which the electronic component is mounted,
a first support plate disposed on the opposite side to the electronic component relative to the board, for supporting the board, and
a second support plate disposed on the opposite side to the board relative to the resin sheet, for supporting the resin sheet.

6. A method for producing an electronic device by adhering a resin sheet to an electronic component using an adhering device,
wherein the adhering device comprises
a first mold member having a first cavity in which an adhering preform can be accommodated, the adhering preform including the electronic component and the resin sheet disposed to face the electronic component in spaced-apart relation,
an elastic member disposed to face the resin sheet so that a first enclosed space can be formed with the first cavity, and
a differential pressure generation means connected to the first mold member for allowing the air pressure of the first enclosed space to be lower than the air pressure of a space opposite to the first enclosed space relative to the elastic member,
wherein the adhering device is configured so that by operating the differential pressure generation means, the elastic member moves towards the first cavity side, and therefore, the adhering preform is pressed in the direction facing the electronic component and the resin sheet, thereby adhering the resin sheet to the electronic component, and
the method comprises,
a placement step in which the adhering perform is placed in the first enclosed space of the adhering device, and
an adhering step in which by operating the differential pressure generation means, the air pressure of the first enclosed space is allowed to be lower than the air pressure of a space opposite to the first enclosed space relative to the elastic member to move the elastic member towards the first cavity side, and therefore, the adhering preform is pressed in the direction facing the electronic component and the resin sheet, thereby adhering the resin sheet to the electronic component.

7. The method for producing an electronic device according to Claim 6, wherein the adhering step comprises
a decompression step in which the pressures of the first enclosed space and the space opposite to the first enclosed space are both decreased, and
a differential pressure generation step in which after the decompression step, by allowing the air pressure of a space opposite to the first enclosed space to be the atmospheric pressure, the air pressure of the first enclosed space is allowed to be lower than the air pressure of the space opposite to the first enclosed space.
